# EUROPÄISCHE PATENTSCHRIFT

(11) **EP 0 402 711 B1**
(45) Veröffentlichungstag und Bekanntmachung des Hinweises auf die Patenterteilung: **12.04.1995**
(21) Anmeldenummer: 90110408.3
(22) Anmeldetag: 01.06.1990
(51) Int. Cl.: H03L 7/089, H04L 7/033

(54) **Schaltungsanordnung zur phasenrichtigen Regenerierung eines Taktsignals**
Circuit arrangement for the correct-phase regeneration of a clock signal
Dispositif pour la régénération d'un signal d'horloge avec une phase correcte

(30) Priorität: 15.06.1989 CH 2243/89
(43) Veröffentlichungstag der Anmeldung: 19.12.1990
(73) Patentinhaber: SIEMENS-ALBIS AKTIENGESELLSCHAFT, 8047 Zürich (CH); SIEMENS AKTIENGESELLSCHAFT, 80333 München (DE)
(72) Erfinder: Wenger, Bruno, CH-8804 AU / ZH (CH)

(56) Entgegenhaltungen:
- EP-A- 0 304 791
- US-A- 3 986 125
- US-A- 4 371 974
- US-A- 4 568 881
- PATENT ABSTRACTS OF JAPAN, Band 10, Nr. 75 (E-390)[2132], 25. März 1986; & JP-A-60 223 224 (MATSUSHITA DENKI SANGYO K.K.) 07-11-1985

## Beschreibung

Die vorliegende Erfindung betrifft eine Schaltungsanordnung nach dem Oberbegriff des Patentanspruchs 1.

Zur Detektierung von z.B. in Kommunikationsnetzwerken übertragenen Daten wird insbesondere für Daten im NRZ-Format ein Taktsignal mit korrekter Phase und Frequenz benötigt. Dieses Taktsignal wird oft mittels einer phasenstarren Regelschleife aus dem empfangenen Datensignal zurückgewonnen bzw. regeneriert. Da sich die Phase des Taktsignals nur langsam ändert, werden zur Taktregenerierung auch entsprechend träge phasenstarre Regelschleifen verwendet, die auch nach längerem Ausbleiben von Signalsprüngen ein phasenrichtiges Taktsignal abgeben. Träge phasenstarre Regelschleifen weisen jedoch einen kleinen Fangbereich auf, weshalb normalerweise noch eine zusätzliche Regelschleife vorgesehen ist, welche die Frequenz des Taktsignals in den Fangbereich der phasenstarren Regelschleife bringt.

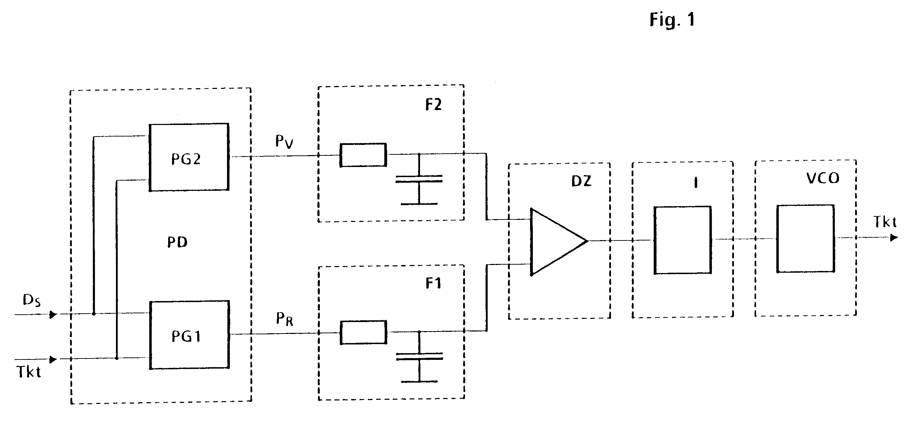

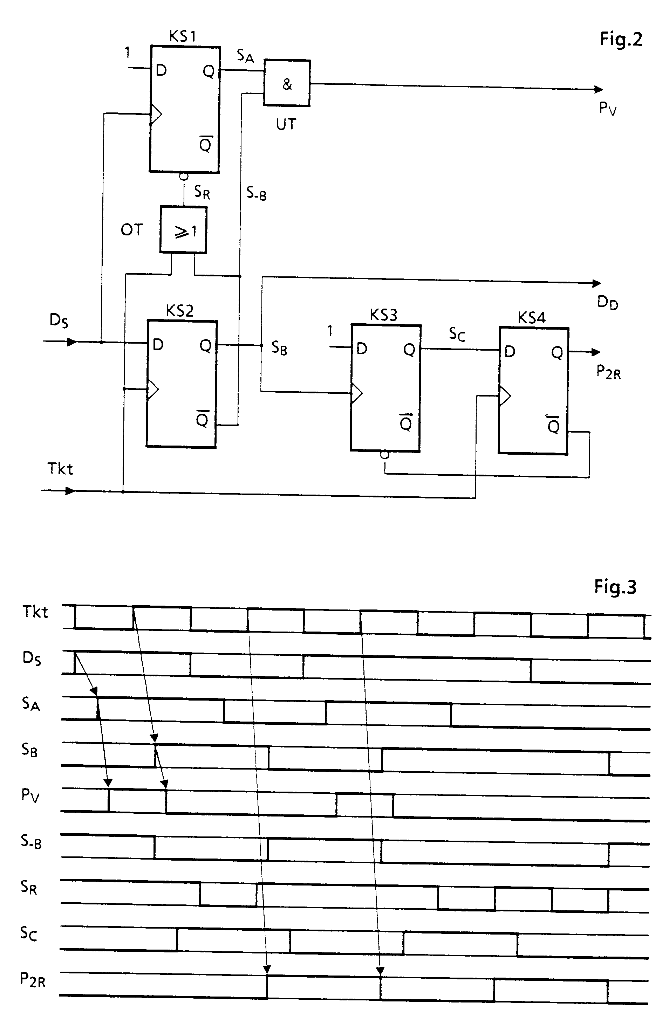

Aus der DE-OS 2061032 ist z.B. eine phasenstarre Regelschleife bekannt, in deren Phasendetektor zwei Signale H und I gebildet werden, die anzeigen, ob die Datenimpulse relativ zum Taktsignal zu früh oder zu spat erscheinen und aus denen durch Differenzbildung und nachfolgende Integration ein Steuersignal für den frequenzvariablen Taktimpulsoszillator gebildet wird. Aus Fig. 1 und 2 der genannten Offenlegungsschrift wird jedoch ersichtlich, dass die Signale H und I nur mit grossem Aufwand erzeugt werden. Dabei werden zur Erzeugung der Signale H und I, welche beide Pulse variabler Länge aufweisen, Verzögerungsschaltungen verwendet, die genau aufeinander abgestimmt sein müssen.

Aus der U.S. 4,371,974 ist eine weitere Taktregenerator-Schaltung bekannt, die einen Phasendetektor aufweist, der für jedes übertragene Datenbit einen unveränderlichen Puls und einen veränderlichen Puls erzeugt, dessen Länge von der Differenz der Phasenlage der übertragenen Datenbits und der Phasenlage des regenerierten Taktsignals abhängt. Durch einen Vergleich des veränderlichen Pulses mit dem unveränderlichen Puls wird danach ein Steuersignal gebildet, das zur Korrektur der Phasenlage des regenerierten Taktsignals einem spannungsgesteuerten Oszillator zugeführt wird. Da bei dieser Schaltungsanordnung die Pulslängen der erzeugten veränderlichen und unveränderlichen Pulse von den Torlaufzeiten der verwendeten Logik-Bausteinen abhängen, ist eine präzise Regenerierung des Taktsignals jedoch nicht möglich (vgl. auch die Dokumente US-A-3 986 125, EP-A-0 304 791 und Patent Abstracts of Japan, Band 10, Nr. 75 (E-390) [2132], 25. März 1986 (& JP-A-60 223 224)).

Der vorliegenden Erfindung liegt daher die Aufgabe zugrunde, eine Schaltungsanordnung anzugeben, die eine präzise und von zeitlichen Verzögerungen verwendeter Bausteine unabhängige Erzeugung des Steuersignals für die phasenstarre Regelschleife ermöglicht.

Die Lösung dieser Aufgabe gelingt mit einer Schaltungsanordnung, wie sie in Anspruch 1 angegeben ist.

Die erfindungsgemässe Schaltungsanordnung besteht vorteilhafterweise nur aus wenigen Logikbausteinen, die derart miteinander verbunden sind, dass alle Torlaufzeiten, die das Steuersignal beeinflussen könnten, sich gegenseitig kompensieren.

Anhand von Zeichnungen wird die erfindungsgemässe Schaltungsanordnung beispielsweise näher erläutert. Dabei zeigt :
- Fig. 1: das Blockschaltbild einer phasenstarren Regelschleife
- Fig. 2: den Phasendetektor der phasenstarren Regelschleife
- Fig. 3: das Zeitdiagramm der im Phasendetektor auftretenden Signale.

Der Phasendetektor PD der in Fig.1 dargestellten phasenstarren Regeschleife enthält zwei Pulsgeneratoren PG1 und PG2, welche beim Eintreffen eines Datenbits D ='1' eines Datensignals D_{S} einen unveränderlichen Puls P_{R} bzw. einen variablen Puls P_{V} über eine Filterstufe F1 bzw. F2 an eine Differenzstufe DZ abgeben, welche die Differenz der anliegenden Signale über einen Integrator 1 als Steuersignal einem spannungsgesteuerten Oszillator VCO zuführt, der ein Taktsignal Tkt erzeugt. Die Filter F1 und F2 dienen in der phasenstarren Regelschleife als Tiefpass bzw. als Schleifenfilter. Schleifenfilter werden z.B. in Roland Best, Theorie und Anwendungen des Phase-locked Loops, 4. Auflage (Aarau 1987), Kapitel 2 beschrieben. Der der Differenzstufe DZ nachgeschaltete Integrator I glättet bzw. integriert das Steuersignal. Dabei entspricht die Länge des unveränderlichen Pulses P_{R} immer der Länge einer halben Periode des Taktsignals Tkt. Möglich ist jedoch auch die Bildung eines unveränderlichen Pulses der Länge einer ganzen Taktperiode der vor der Zuführung an die Differenzstufe DZ halbiert wird. Falls das Taktsignal Tkt relativ zum Datensignal D_{S} jedoch phasen- und/oder frequenzverschoben auftritt, werden relativ zu den unveränderlichen Pulsen P_{R} kürzere (bei vorgeschobener Phase) oder längere (bei verzögerter Phase) Pulse P_{V} erzeugt. Das sich nach der Differenzbildung ergebende Steuersignal ergibt im spannungsgesteuerten Oszillator eine entsprechende Korrektur des Taktsignals Tkt. Falls das Taktsignal Tkt jedoch relativ zum Datensignal D_{S} mit korrekter Frequenz und Phasenlage auftritt, erzeugt der Pulsgenerator PG2 variable Pulse P_{V}, die ebenso wie die Pulse P_{R} der Länge einer halben Taktperiode entsprechen. Nach der Differenzbildung in der Differenzstufe DZ ergibt sich folglich keine Veränderung des dem spannungsgesteuerten Oszillator VCO zugeführten Steuersignals.

Das heisst, der unveränderliche Puls P_{R} und im eingeregelten Zustand der variable Puls P_{V} müssen immer einer halben Taktperiode entsprechen. Eine Verkürzung oder Verlängerung beider Pulse P_{V} und P_{R} um dasselbe Mass ist jedoch zulässig, da sich diese Abweichungen beim Pulslängenvergleich in der Differenzstufe DZ wieder aufheben. Bei Verwendung von digitalen Phasendetektoren ist es deshalb wichtig, dass die Pulslängen der Pulse P_{V} und P_{R} durch die Laufzeiten der verwendeten Bauteile nicht oder nur symmetrisch verändert werden. Die Einhaltung dieser Bedingung ist speziell bei hohen Taktfrequenzen wichtig, da in diesen Fällen die Torlaufzeiten digitaler Bauteile gross im Verhältnis zu einer Taktperiode werden.

In der Schaltungsanordnung von Fig. 2 wird diese Bedingung folgendermassen eingehalten : Die aufsteigende Flanke eines Datenbits D = '1' erzeugt am nicht invertierenden Ausgang der Kippstufe KS1 eine logisch '1', welche am Ausgang des Und-Tores UT den Puls P_{V} auslöst. Das Erscheinen der aufsteigenden Flanke des Pulses P_{V} wurde folglich um die Laufzeiten der Kippstufe KS1 und des Und-Tores UT verzögert. Beim Eintreffen einer aufsteigenden Flanke des Taktsignals Tkt wird der invertierende Ausgang der Kippstufe KS2 zurückgesetzt, wonach der Ausgang des Und-Tores UT den Wert logisch '0' annimmt. Das Erscheinen der abfallenden Flanke des Pulses P_{V} wurde folglich um die Laufzeiten der Kippstufe KS2 und des Und-Tores UT um dasselbe Mass verzögert wie das Erscheinen der aufsteigenden Flanke. Der variable Puls P_{V} wurde demnach zeitlich verschoben, jedoch in korrekter Länge erzeugt.

Nach dem Eintreffen der aufsteigenden Flanke eines Datenbits D = '1' und der nächsten darauffolgenden aufsteigenden Flanke des Taktsignals Tkt wird der nicht invertierende Ausgang der Kippstufe KS2 auf logisch '1' gesetzt. Der invertierende Ausgang der Kippstufe KS2 wird auf logisch '0' zurückgesetzt, was wie oben beschrieben, über das Und-Tor UT zur Beendigung des Pulses P_{V} führt. Durch das Setzen des nichtinvertierenden Ausgangs der Kippstufe KS2 erhält die Kippstufe KS3 einen Taktimpuls, worauf deren nichtinvertierender Ausgang auf logisch '1' gesetzt wird. Die nächstfolgende aufsteigende Flanke des Taktsignals Tkt setzt den nichtinvertierenden Ausgang der Kippstufe KS4, der einen unveränderlichen Puls P_{2R} abgibt. Gleichzeitig wird durch das Erscheinen von logisch '0' am invertierenden Ausgang der Kippstufe KS4 die Kippstufe KS3 zurückgesetzt. Mit dem Erscheinen der nächsten aufsteigenden Flanke des Taktsignals Tkt wird in der Folge auch die Kippstufe KS4 zurückgesetzt. Der Puls P_{2R} wird demnach entsprechend der Länge einer Taktperiode des Taktsignals Tkt erzeugt. Vor dem Vergleich der Pulse P_{V} und P_{R} in der Differenzstufe DZ muss der Puls P_{2R} noch halbiert werden, damit die eingangs erwähnte Bedingung eingehalten wird. (Pulslänge von P_{R} entsprechend einer halben Taktperiode). Der Puls P_{R} wird dabei durch Halbierung des Pulses P_{2R} in einer Teilerstufe T_{1/2} erzeugt, die vor oder nach dem Schleifenfilter F1 (siehe Fig. 1) eingefügt wird. Falls die Torlaufzeiten der Kippstufen KS3 und KS4 im Verhältnis zu einer Taktperiode genügend kurz sind, so kann der Puls P_{R} bereits am Ausgang der Kippstufe KS4 in korrekter Länge d.h. entsprechend der Länge einer halben Taktperiode erzegt werden, indem dem Takteingang der Kippstufe KS4 ein Signal mit doppelter Frequenz des Taktsignals Tkt zugeführt wird oder falls die Kippstufe KS4 derart gewählt wird, dass sie durch die aufsteigende und abfallende Flanke des Taktsignals Tkt getaktet wird. Letzteres bedingt ein Tastverhältnis des Taktsignals Tkt von 1:1. Aus Fig.3 ist ferner ersichtlich, dass in der beschriebenen Schaltung für mehrere zusammmenhängende Datenbits D = '1' ebenso wie für ein alleinstehendes Datenbit D = '1' einfachheitshalber nur je ein Puls P_{V} und P_{R} erzeugt wird.

In Fig.3 wird das der Logikschaltung aus Fig. 2 entsprechende Zeitdiagramm gezeigt. Dabei wird das Signal S_{A} vom nichtinvertierenden Ausgang der Kippstufe KS1, das Signal S_{-B} vom invertierenden und das Signal S_{B} vom nichtinvertierenden Ausgang der Kippstufe KS2, das Signal S_{C} vom nichtinvertierenden Ausgang der Kippstufe KS3 und das Signal S_{R} vom Ausgang des Oder-Tores OT abgegeben.

Die aufsteigende Flanke des Datenbits D = '1' löst nach einer Verzögerung durch die Torlaufzeit t_{KS1} eine logisch '1' des Signals S_{A} (Bedingung: Signal S_{R} = '1') und nach der Torlaufzeit t_{UT} einen variablen Puls P_{V} (Bedingung: Signal S_{B} = '1') aus. Die der aufsteigenden Flanke des Datenbits D = '1' folgende, aufsteigende Flanke des Taktsignals Tkt löst nach einer Verzögerung durch die Torlaufzeit t_{KS2} eine logisch '1' des Signals S_{B} aus und setzt das Signal S_{-B} auf logisch '0' zurück, worauf nach der Torlaufzeit t_{UT} der variable Puls P_{V} beendet wird. Das Resetsignal S_{R} wird für S_{-B} und Tkt = '0' nach der Torlaufzeit t_{OT} auf logisch '0' gesetzt, worauf die Kippstufe KS1 nach der Torlaufzeit t_{KS1} zurückgesetzt wird (Signal S_{A} wird = '0'). Die logisch '1' des Signals S_{B} setzt nach der Torlaufzeit t_{KS3} das Signal S_{C} auf logisch '1'. Die nächstfolgende aufsteigende Flanke des Taktsignals Tkt löst nach der Torlaufzeit t_{KS4} den Puls P_{R} aus. Durch die logisch '0', welche zu diesem Zeitpunkt am invertierenden Ausgang der Kippstufe KS4 erscheint, wird die Kippstufe KS3 bzw. das Signal S_{C} auf logisch '0' zurückgesetzt. Beim Eintreffen der nächstfolgenden aufsteigenden Flanke des Taktsignals Tkt wird der Puls P_{2R} folglich nach der Torlaufzeit t_{KS4} beendet und entspricht demnach genau einer Taktperiode des Taktsignals Tkt. Damit sich die Torlaufzeiten gegenseitig aufheben, sollten sie in der Praxis für alle entsprechenden Logikbauteile zumindest annähernd gleich sein. Im Zeitdiagramm von Fig.3 wurde die Torlaufzeit für alle Kippstufen gleich 2/10 und die Torlaufzeit der Und- bzw. Oder-Tore gleich 1/10 einer Periodendauer des Taktsignals Tkt gewählt. Durch verschiedene Pfeile sind im Zeitdiagramm die Zeitabstände zwischen auslösenden und ausgelösten Flanken einiger Signale gezeigt. Daraus wird ersichtlich, dass die aufsteigenden und abfallenden Flanken des variablen Pulses P_{V} bzw. P_{2R} um dasselbe Mass zeitlich verschoben und die Pulse P_{V} und P_{2R} folglich mit korrekter Pulslänge erzeugt wurden. Der Puls P_{2R} muss jedoch nachfolgend in einer Teilerstufe halbiert werden.

Das Zeitdiagramm von Fig. 3 wurde im eingeregelten Zustand der phasenstarren Regelschleife aufgenommen. Das heisst, die aufsteigenden Flanken des Taktsignals Tkt fallen genau in die Mitte der Dateneinsen und Datennullen. Die Kippstufe KS2, der das Datensignal D_{S} zugeführt wird und die jeweils durch die aufsteigenden Flanken des Taktsignals Tkt getaktet wird, detektiert folglich die eintreffenden Daten und gibt sie vom nichtinvertierenden Ausgang als Signal S_{B} sowohl an den Ausgang des Phasendetektors als auch an den Takteingang der Kippstufe KS3 weiter.

## Patentansprüche

1. Schaltungsanordnung zur phasenrichtigen Regenerierung eines Taktsiganls (Tkt) aus einem übertragenen Datensignal (D_{S}) mit einem Phasendetektor (PD), dem die übertragenen Daten (D_{S}) und das regenerierte Taktsignal (Tkt) zugeführt werden und der für jedes übertragene Datenbit D='1' einen unveränderlichen Puls (P_{R}) und einen von der relativen Phasenlage der übertragenen Daten abhängenden veränderlichen Puls (P_{V}) an eine Differenzstufe (DZ) abgibt, deren Ausgang mit dem Eingang eines spannungsgesteuerten Oszillators (VCO) verbunden ist, welcher das regenerierte Taktsignal (Tkt) abgibt, **dadurch gekennzeichnet,** dass die übertragenen Daten (D_{S}) dem Takteingang einer ersten Kippstufe (KS 1) und dem Eingang (D) einer zweiten Kippstufe (KS2) zugeführt werden, dass das regenerierte Taktsignal (Tkt) den Takteingängen der zweiten Kippstufe (KS2) und einer vierten Kippstufe (KS4) sowie dem ersten Eingang eines Oder-Tores (OT) zugeführt wird, dessen Ausgang mit dem invertierenden Reseteingang der ersten Kippstufe (KS1) verbunden ist, dass der nichtinvertierende Ausgang der Kippstufe (KS1) mit dem ersten Eingang eines Und-Tores (UT) verbunden ist, welches die variablen Pulse (P_{V}) abgibt, dass der invertierende Ausgang der zweiten Kippstufe (KS2) je mit dem zweiten Eingang des Oder-Tores (OT) und des Und-Tores (UT) verbunden ist, dass der nicht invertierende Ausgang der zweiten Kippstufe (KS2) mit dem Takteingang einer dritten Kippstufe (KS3) verbunden ist, dass der nichtinvertierende Ausgang der dritten Kippstufe (KS3) mit dem Eingang (D) der vierten Kippstufe (KS4) verbunden ist, deren invertierender Ausgang mit dem invertierenden Reseteingang der dritten Kippstufe (KS3) verbunden ist und deren nicht invertierender Ausgang Pulse (P_{2R}) der Länge einer ganzen Taktperiode abgibt, und dass die Eingänge (D) der ersten oder dritten Kippstufen (KS1, KS3) mit einem dem Wert logisch '1' entsprechenden Potential verbunden sind.

2. Schaltungsanordnung nach Anspruch 1, **dadurch gekennzeichnet,** dass der Ausgang der vierten Kippstufe (KS4) und der Ausgang des Und-Tores (UT) je mit einem Schleifenfilter (F1, F2) verbunden sind, wobei der Ausgang des Schleifenfilters (F1) mit einer Teilerstufe (T_{1/2}) verbunden ist, welche ihr zugeführte Signale halbiert, dass der Ausgang der Teilerstufe (T_{1/2}) und der Ausgang des Schleifenfilters (F2) je mit einem Eingang einer Differenzstufe (DZ) verbunden sind, welche das Differenzsignal (P_{V} - P_{R}) der beiden Pulse (P_{V}, P_{R}) an einen Integrator (I) abgibt, dessen Ausgang mit dem Eingang des spannungsgesteuerten Oszillators (VCO) verbunden ist.

3. Schaltungsanordnung nach Anspruch 1, **dadurch gekennzeichnet,** dass der Ausgang der vierten Kippstufe (KS4) mit einer Teilerstufe (T_{1/2}) verbunden ist, welche ihr zugeführte Signale halbiert, und dass der Ausgang der Teilerstufe (T_{1/2}) und der Ausgang des Und-Tores (UT) je mit einem Schleifenfilter (F1, F2) verbunden sind, wobei die Ausgänge der Schleifenfilter (F1, F2) je mit einem Eingang einer Differenzstufe (DZ) verbunden sind, welche das Differenzsignal (P_{V} - P_{R}) der beiden Pulse (P_{V}, P_{R}) an einen Integrator (I) abgibt, dessen Ausgang mit dem Eingang des spannungsgesteuerten Oszillators (VCO) verbunden ist.

4. Schaltungsanordnung nach Anspruch 1, **dadurch gekennzeichnet,** dass dem Takteingang der vierten Kippstufe (KS4) ein Signal mit doppelter Frequenz des Taktsignals (Tkt) zugeführt wird, oder dass die vierte Kippstufe (KS4) so gewählt wird, dass sie durch die aufsteigende und abfallende Flanke des Taktsignals (Tkt) getaktet wird, wodurch am Ausgang der vierten Kippstufe (KS4) der unveränderliche Puls (P_{R}) entsprechend der halben Taktperiode des Taktsignals (Tkt) erzeugt wird.

5. Schaltungsanordnung nach Anspruch 1, 2, 3 oder 4, **dadurch gekennzeichnet,** dass der nichtinvertierende Ausgang der zweiten Kippstufe (KS2), welcher das Signal (S_{B}) bzw.die detektierten Empfangsdaten (D_{D}) abgibt, den Ausgang der Schaltungsanordnung bildet.

## Claims

1. Circuit arrangement for the in-phase regeneration of a clock signal (Tkt) from a transmitted data signal (D_{S}) with a phase detector (PD) to which the transmitted data (D_{S}) and the regenerated clock signal (Tkt) are delivered and which for each transmitted data bit D='1' emits a fixed pulse (P_{R}) and a variable pulse (P_{V}) dependent on the relative phase position of the transmitted data to a differential stage (DZ) of which the output is connected to the input of a voltage-controlled oscillator (VCO) which emits the regenerated clock signal (Tkt), characterized in that the transmitted data (D_{S}) are delivered to the clock input of a first flip-flop (KS 1) and to the input (D) of a second flip-flop (KS2); in that the regenerated clock signal (Tkt) is delivered to the clock inputs of the second flip-flop (KS2) and of a fourth flip-flop (KS4) and to the first input of an OR gate (OT) of which the output is connected to the inverting reset input of the first flip-flop (KS1); in that the non-inverting output of the flip-flop (KS1) is connected to the first input of an AND gate (UT) which emits the variable pulses (P_{V}); in that the inverting output of the second flip-flop (KS2) is connected in each case to the second input of the OR gate (OT) and of the AND gate (UT); in that the non-inverting output of the second flip-flop (KS2) is connected to the clock input of a third flip-flop (KS3); in that the non-inverting output of the third flip-flop (KS3) is connected to the input (D) of the fourth flip-flop (KS4) of which the inverting output is connected to the inverting reset input of the third flip-flop (KS3) and of which the non-inverting output emits pulses (P_{2R}) of the length of a whole elementary period; and in that the input (D) of the first or third flip-flop (KS1, KS3) is connected to a potential corresponding to the value logical '1'.

2. Circuit arrangement according to Claim 1, characterized in that the output of the fourth flip-flop (KS4) and the output of the AND gate (UT) are each connected to a loop filter (F1, F2), the output of the loop filter (F1) being connected to a divider stage (T_{1/2}) which halves the signals delivered thereto; and in that the output of the divider stage (T_{1/2}) and the output of the loop filter (F2) are each connected to an input of a differential stage (DZ) which emits the differential signal (P_{V} - P_{R}) of the two pulses (P_{V}, P_{R}) to an integrator (I) of which the output is connected to the input of the voltage-controlled oscillator (VCO).

3. Circuit arrangement according to Claim 1, characterized in that the output of the fourth flip-flop (KS4) is connected to a divider stage (T_{1/2}) which halves the signals delivered thereto; and in that the output of the divider stage (T_{1/2}) and the output of the AND gate (UT) are each connected to a loop filter (F1, F2), the outputs of the loop filters (F1, F2) each being connected to an input of a differential stage (DZ) which emits the differential signal (P_{V} - P_{R}) of the two pulses (P_{V}, P_{R}) to an integrator (I) of which the output is connected to the input of the voltage-controlled oscillator (VCO).

4. Circuit arrangement according to Claim 1, characterized in that a signal with twice the frequency of the clock signal (Tkt) is delivered to the clock input of the fourth flip-flop (KS4); or in that the fourth flip-flop (KS4) is selected such that it is clocked by the rising and falling edges of the clock signal (Tkt) whereby the fixed pulse (P_{R}) is generated at the output of the fourth flip-flop (KS4) in accordance with the half elementary period of the clock signal (Tkt).

5. Circuit arrangement according to Claim 1, 2, 3 or 4, characterized in that the non-inverting output of the second flip-flop (KS2) which emits the signal (S_{B}) or the detected received data (D_{D}) forms the output of the circuit arrangement.

## Revendications

1. Montage destiné à régénérer avec une phase correcte un signal de cadence (Tkt) à partir d'un signal (D_{S}) de données transmis, comportant un détecteur de phase (PD), auquel sont envoyées les données (D_{S}) transmises et le signal de cadence régénéré (Tkt) et qui fournit, pour chaque bit de données transmis D = "1", une impulsion invariable (P_{R}) et une impulsion variable (P_{V}) dépendant de la position relative des phases des données transmises, à un étage (DZ) de formation d'une différence, dont la sortie est reliée à l'entrée d'un oscillateur (VCO) commandé en tension, lequel fournit le signal de cadence régénéré (Tkt), caractérisé en ce que les données transmises (D_{S}) sont envoyées à l'entrée de cadence d'une première bascule (KS1) et à l'entrée (D) d'une seconde bascule (KS2), le signal de cadence régénéré (Tkt) est envoyé aux entrées de cadence de la seconde bascule (KS2) et d'une quatrième bascule (KS4) ainsi qu'à la première entrée d'une porte OU, (OT), dont la sortie est reliée à l'entrée inverseuse de réinitialisation de la première bascule (KS1), la sortie non inversée de la bascule (KS1) est reliée à la première entrée d'une porte ET, (UT), qui fournit les impulsions variables (P_{V}), la sortie inverseuse de la seconde bascule (KS2) est reliée à la seconde entrée de la porte OU (OT) et de la porte ET (UT), la sortie non inverseuse de la seconde bascule (KS2) est reliée à l'entrée de cadence d'une troisième bascule (KS3), la sortie non inverseuse de la troisième bascule (KS3) est reliée à l'entrée (D) de la quatrième bascule (KS4), dont la sortie inverseuse est reliée à l'entrée inverseuse de réinitialisation de la troisième bascule (KS3) et dont la sortie non inverseuse fournit des impulsions (P_{2R}) ayant la longueur d'une période entière de cadence, et les entrées (D) des première et troisième bascules (KS1, KS3) sont reliées à un potentiel correspondant à la valeur logique "1".

2. Montage suivant la revendication 1, caractérisé en ce que la sortie de la quatrième bascule (KS4) et la sortie de la porte ET (UT) sont chacune reliées à un filtre de boucle (F1, F2), la sortie du filtre de boucle (F1) étant reliée à un étage diviseur (T_{1/2}), lequel divise par deux les signaux qui lui sont envoyés, la sortie de l'étage diviseur (T_{1/2}) et la sortie du filtre de boucle (F2) sont chacune reliées à une entrée d'un étage (DZ) de formation de différence, lequel fournit le signal de différence (P_{V}-P_{R}) des deux impulsions (P_{V}, P_{R}) à un intégrateur (I), dont la sortie est reliée à l'entrée de l'oscillateur (VCO) commandé en tension.

3. Montage suivant la revendication 1, caractérisé en ce que la sortie de la quatrième bascule (KS4) est reliée à un étage diviseur (T_{1/2}), lequel divise par deux les signaux qui lui sont envoyés, et la sortie de l'étage diviseur (T_{1/2}) et la sortie de la porte ET (UT) sont chacune reliées à un filtre de boucle (F1,F2), les sorties des filtres de boucle (F1,F2) étant chacune reliées à une entrée d'un étage (DZ) de formation de différence, qui fournit le signal de différence (P_{V}-P_{R}) des deux impulsions (P_{V}, P_{R}) à un intégrateur (I), dont la sortie est reliée à l'entrée de l'oscillateur (VCO) commandé en tension.

4. Montage suivant la revendication 1, caractérisé en ce qu'il est envoyé à l'entrée de cadence de la quatrième bascule (KS4) un signal de fréquence double de celle du signal de cadence (Tkt) ou que la quatrième bascule (KS4) est choisie de sorte à être cadencée par le front montant et descendant du signal de cadence (Tkt), ce qui produit, à la sortie de la quatrième bascule (KS4), une impulsion invariable (P_{R}) qui correspond à la demi-période de cadence du signal de cadence (Tkt) .

5. Montage suivant l'une des revendications 1, 2, 3 ou 4, caractérisé en ce que la sortie non inverseuse de la seconde bascule (KS2), qui fournit le signal (S_{B}) et les données (D_{D}) de réception détectées, forme la sortie du montage.
